# EUROPEAN PATENT SPECIFICATION

(11) **EP 0 725 978 B1**
(45) Date of publication and mention of the grant of the patent: **08.01.2003**
(21) Application number: 95931948.4
(22) Date of filing: 31.08.1995
(51) Int. Cl.: H01L 21/00

(54) **METHOD OF PRODUCING A QUARTZ GLASS JIG FOR THE HEAT TREATMENT OF SILICON WAFERS**
VERFAHREN ZUR HERSTELLUNG EINER QUARZGLAS-HALTEVORRICHTUNG ZUR WÄRMEBEHANDLUNG VON SILIZIUM-WAFERN
PROCEDE DE PRODUCTION D'UN GABARIT DE VERRE QUARTZEUX DESTINE AU TRAITEMENT THERMIQUE DE PLAQUETTES DE SILICIUM

(30) Priority: 31.08.1994 JP 22896794; 31.08.1994 JP 22896894
(43) Date of publication of application: 14.08.1996
(73) Proprietor: Heraeus Quarzglas GmbH & Co. KG, 63450 Hanau (DE); SHIN-ETSU QUARTZ PRODUCTS CO., LTD., Shinjuku-ku, Tokyo (JP)
(72) Inventor: KEMMOCHI, Katsuhiko, Fukushima (JP)
(74) Representative: Kühn, Hans-Christian
(86) International application number: EP9503418
(87) International publication number: WO96007199

(56) References cited:
- EP-A- 0 420 122
- DE-U- 8 814 987
- GB-A- 2 082 388
- US-A- 3 640 398
- US-A- 4 738 573

## Description

### Industrial Field of Application

The present invention relates to a method for producing a quartz glass jig for heat treatment of silicon wafers comprising a silicon wafer resting member, having a quartz glass board in and along which wafer resting grooves are formed.

### Prior Art

Quartz glass has been used as a jig for heat-treating silicon semiconductor devices because it is higher in purity as compared with other refractory materials and coalescence by welding is possible.
The recent increase in the packing density of a semiconductor device and the appearance of newly developed devices in which an impurity is extremely intolerable such as flash memory require further purified quartz glass.
Under such circumstances in order to meet the requirement, high purity natural quartz crystal powders, synthesized quartz glass powders and the like have been developed and are available.
Particularly as to synthesized quartz glass powders, the extremely highly pure powders of 0.1 ppm or less in the total concentration of metal impurities are now available in an industrial scale.

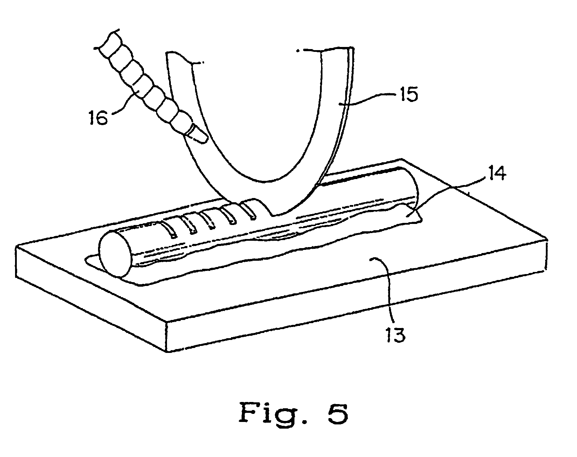

A conventional quartz glass jig for heat-treating semiconductor jig is produced, in sequence, in the following steps of:
extruding a round rod of each of the aforementioned high purity materials from a round nozzle such as disclosed in British Patent Publication No.400,472;
fixing each round rod with wax 14 on an iron surface plate 13 as shown in FIG.5;
cutting wafer resting grooves along the round rod with a rotating diamond blade 15 to fabricate a silicon wafer resting member; and
welding a supporting member constructed from the round rods integrally with the wafer resting members using oxygen-hydrogen flame as a heat source.

Automation of loading silicon wafers and transferring a jig into a heat-treatment furnace have been practicable, because dimensional precision can be achieved in such machining as above-mentioned.

Microcracks occur due to brittteness in the surface region of quartz glass up to a depth of sometimes more than 100 µm, when cutting is carried out on the surface.
Such impurities as Na, Ka, Li, Ca, Cu, Fe, Ni and the like which are originated from tools and a coolant are incorporated into the microcracks. Therefore there was a problem that silicon wafers were contaminated when they were heat-treated. In this state, if the surface region of more than 100 µm in depth is etched off in a cleaning operation, the newly exposed surface region can become pure, but that with an adverse effect of a sacrificed dimensional precision of the surface.

There are chances in some actual cases that the dimensional precision and purity level of the surface are not compatible with each other. Particularly, when machining with a dimensional precision of ± 5/100 (mm) is intended that is required for automatic silicon wafer loading, both of occurrence of microcracks and incorporation of impurities have been almost unavoidable at the same time.

From US 4,738,573 a slot plunge cutter for processing a silicon wafer boat carrier is known. This invention refers to a cutting machine with slotting blades, which cut a plurality of vertical slots into a jig member made of quartz glass. The slots function as grooves for carrying silicon wafers therein. The method according to US 4,738,573 is a mechanically working method only.

An other way of producing wafer carriers is disclosed in US 3,640,398. No slot-cutting operations are practised according to US 3,640,398, but the carriers are formed by clamping several rods together and thereafter weld these parts to the desired shape of the wafer carrier. For welding a fine-tip hydrogen-oxygen torch is jused.

To avoid contamination of silicon wafers during heat treatment high-purity quartz glass jigs are used. Accordingly, in an attempt to fabricate jigs of higher purity, better techniques for refining quartz stock have been developed. Also, techniques for fabricating high-purity synthetic quartz glasses from high-purity industrial chemicals have been developed. Especially, for the synthetic quartz glasses, it is possible to industrially produce those synthetic quartz glasses which have extremely high degrees of purity (i.e., the total amount of metal impurities is not in excess of 0.1 ppm). Moreover, it has been possible to implant several ppm desired additive without mixing other impurities (e.g., 1 ppm aluminum is added) to impart heat resistance to such quartz glasses. However, if a jig is fabricated from such high-purity quartz glass, and if silicon wafers are heat-treated in a high-purity ambient, then it is difficult to avoid contamination due to alkali elements, especially sodium. Consequently, it has been impossible to overcome the disadvantage that high-grade devices are manufactured at low yield.

Furthermore it has been found that sodium contamination of wafers is not directly caused by the ambient gas but attributed to contamination of the jig on which the wafers are placed. The contamination of the wafer resting member is not limited to the period for which the silicon wafers are being thermally processed but starts already during annealing of quartz glass fabricated by glass blowing. If a sodium contamination source such as heat-insulating material around a heat-treatment furnace is coupled to wafers via a quartz glass base member to thereby form a direct contact path, then sodium contaminates the wafers.

### Problems to be Solved by the Invention

In light of the present state of the art, it is accordingly an object of the present invention to provide a method for producing a quartz glass jig for heat-treating semiconductor devices having a dimensional precision and surface cleanliness so that the silicon wafers resting on the resting grooves are not contaminated.

### Means to Solve the Problem

The present inventor has been making efforts on a study and as a result discovered the fact that a quartz glass jig for heat treating semiconductor devices without the faults above-mentioned was obtainable by a method for producing such quartz glass jig wherein the wafer resting grooves are formed by laser beam machining. The invention therefore provides a method as defined in claim 1.

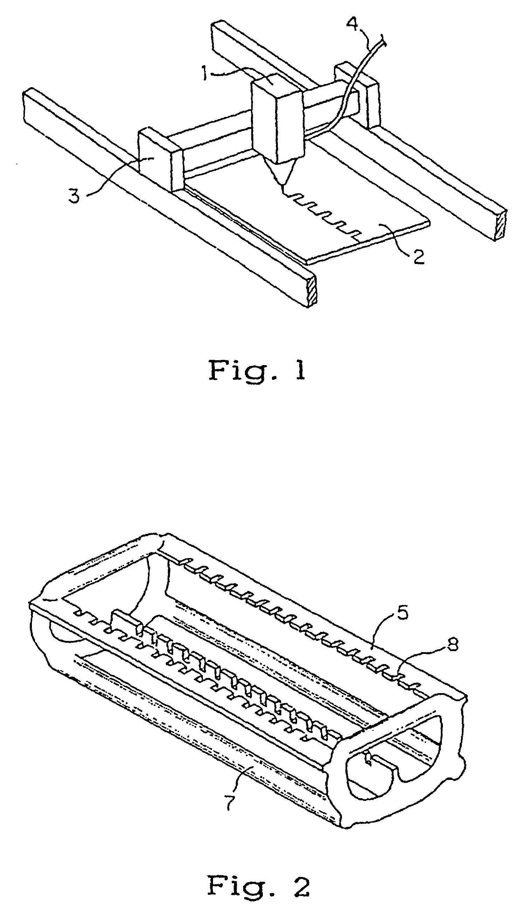

The quartz glass jig for heat-treating silicon wafers comprises as shown in FIG.2 silicon wafer resting members 5 and a supporting member 7 for supporting the wafer resting members 5, where wafer resting positions 8 such as grooves or teeth are provided for the respective wafer resting members 5.
The silicon wafers 6 are loaded in this jig and transferred into a electric furnace for heating the wafers 6 at a temperature around 1000 °C and at the same time for forming an oxide film on the surface each.

In the above treatment, when such impurities as Na, Ka and other alkali elements, Fe, Ni and Ca are present in the surface region of the quartz glass, the impurities are released out and the silicon wafers are contaminated.
The surface region of a depth up to 30 µm of quartz glass forming a jig preferably has such a purity level that concentrations of Na, Ka, Fe and Ca are respectively 0.4 ppm or less, 0.2 ppm or less, 0.4 ppm or less, and 0.8 ppm or less.
In order to achieve this purity level, according to an embodiment of the present invention, raw material having the above-mentioned purity level is used and an extrusion molding method is applied to such raw material to produce each part of the jig.
It is not preferable and to be avoided that each board for a wafer resting member is molded excessively thick and later thinned by grinding or the like to adjust the thickness and in another case boards are sliced from a large block, since these kinds of processing cause microcracks in the surface. Such mechanical processing is also undesirable because metal powders that are a cooling agent for a diamond tool have chances to adhere the quartz glass surface.
Each part of a quartz glass jig is preferably molded by extrusion into dimensions close to the predetermined, where molding by extrusion does not means only a method that a molten substance is extruded under pressure through an opening.
For example, methods are included in the sense of molding by extrusion that boards as formed are further extended out through feed rollers and in another case feed rollers generating an torque working in such a manner as to move up a board are used so as to prevent the board from free fall under the gravity and thereby the board is descending at a constant speed. Further, included in this sense are a method to pull up a board upward, a method to extend it sideways and the other variations. All these variations are applicable as far as the board is formed directly by molding and cutting or grinding is not necessary in a following step.

A silicon wafer resting member 5 is fabricated from a quartz glass board, since the wafer resting member is hard to be processed by laser beam machining from starting materials not uniform in thickness.

When starting from a quartz glass board, a processing high in dimensional precision is realized by laser beam machining as shown in FIG.1 and automatic loading of wafers and automatic transfer of a jig is thus made possible.

As to methods of producing a quartz glass board, it will be enough if a method disclosed in a publication of Unexamined Japanese Patent Application No.4-55332 and a method disclosed in a Japanese publication of PCT Patent Application No.94/3404 are used. All has to do is to adopt a most applicable method in consideration both of a design of a jig and of the number of the jigs to be produced.

It is preferable to construct a supporting member for supporting silicon wafer resting members with round rods in terms of working efficiency. The round rods are welded to form a jig such as silicon wafer boat as shown in FIG.2, where a numeral 5 indicates silicon wafer resting members, a numeral 7 indicates a supporting member and a numeral 8 indicates grooves for resting wafers.

Laser beam machining as shown in FIG.1 is best applied to formation of the grooves 8, where a quartz glass board 2 is placed on a working table for laser beam machining to cut grooves 8 for resting the waters, where the CO2 gas laser 1 is displaced by supporting arms 3 on rails. During laser beam machining, Ar assist gas 4 is blown into a groove 8 under cutting so as not to have a fume remain in the groove 8.The output power of laser beam for cutting is so adjusted as to obtain a smooth surface. The cutting of a dimensional precision of ± 0.05 mm is executable, if position control in the cutting process is made by the unit of 1 µm. Some of the fume has a chance to remain in the neighborhood of the cutting surface in such a degree as to have a faint change of the color, even if the Ar assist gas is blown. Therefore, the color-changed portion is etched off by dipping in a diluted hydrofluoric acid. No crack occurs and the surface is smoothed, by adopting laser beam machining.

In laser beam machining, cutting a groove on a round rod is hard due to lack of uniformity in the depths to be cut around the rod surface. Boards as molded by extrusion have a thickness variation of ± at most about 0.3 mm and this variation does not adversely affect the uniformity of processing in laser beam machining. Boards as molded by extrusion are therefore preferably used in the present invention.

The coverage of laser beam machining on the surface in the neighborhood of a wafer resting position is enough if it is conducted throughout the surface portion within 2 cm of the contact point with the silicon wafer inserted. With no laser beam machining beyond the surface portion, contamination of silicon wafers does not occur, even though diamond processing is applied there.

Examples of the method for producing the jig of the present invention will be described below in reference to the accompanying drawings, together with examples of jigs which may be produced by said method.

### Brief Description of the Drawings

- **FIG. 1**: is a schematic perspective view of a laser beam machine for processing wafer resting members according to the method of the present invention.
- **FIG. 2**: is a perspective view of a horizontal quartz glass jig for heat treatment.
- **FIG. 3**: is a schematic cross-sectional view of a production apparatus of round rods constructing a jig.
- **FIG. 4**: is a schematic cross-sectional view of a production apparatus of boards constructing a jig.
- **FIG. 5**: is a schematic view of a prior art production apparatus of a conventional quartz glass jig for heat-treating semiconductor devices.

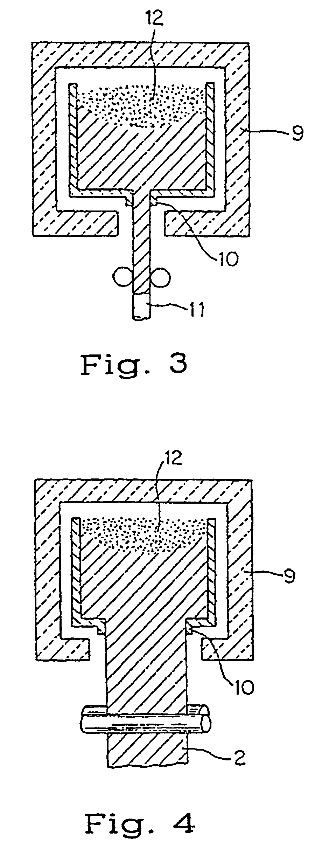

High purity quartz crystal powders 12 are supplied in an electric furnace 9 as shown in FIGS. 3 and 4, molten by heating.
The molten quartz is then extruded through the nozzle 10 to produce a quartz glass rod 11 or a quartz glass board 2.
Each of the thus produced quartz glass boards 2 is set in a laser beam machine as shown in FIG.1, grooves for resting silicon wafers 8 are cut and then the machined quartz glass boards 2 and a supporting member 7 constructed from the quartz glass rods 11 are electrically welded with one another to complete a silicon wafer boat as shown in FIG.2.

The method as described above relates to an example of the horizontal furnace boats, and a vertical furnace boat is also fabricatable forming grooves or teeth 8 for resting wafers by means of a similar method to that as mentioned above.

### Examples

### Example 1

Quartz crystal powders of raw material were treated by floatation and electromagnetic separation, washed in hydrofluoric acid and nitric acid and further refined with a mixed gas of chlorine and hydrogen chloride at 1100 °C. As a result, quartz crystal powders with such an impurity level as a concentration of Fe less than 0.05 ppm, a concentration of Na less than 0.05 ppm, a concentration of Ka less than 0.05 ppm and a concentration of Ca less than 0.5 ppm were obtained.
The thus treated quartz crystal powders were heated in a molybdenum crucible disposed in an electric furnace 9 at 2200 °C to be transformed to transparent quartz glass. The quartz glass was then molded with a extruder as shown in FIGS.3 and 4 into round rods 11 of 15 mm in diameter and boards 2 of 4 mm thick and 35 cm wide.

Grooves for resting wafers 8 were cut in and along some of the boards by means of a method of laser beam machining as shown in FIG.1 to complete wafer resting members 5 and next the wafer resting members 5 were welded to assemble a silicon wafer boat. The thus produced silicon wafer boat was washed in a hydrofluoric acid of 4.5 % in concentration for 3 minutes to remove the adhered fume and surface contamination.
The internal surface in each of the grooves for resting wafers 8 was smooth.
The impurities in the surface region up to 30 µm in depth of the jig, that is the silicon wafer boat, were measured after etching by hydrofluoric acid of the whole surface region and the results expressed on the average were as follows:
The concentration of Fe was less than 0.05 ppm, the concentration of Na was less than 0.05 ppm, the concentration of Ka was less than 0.05 ppm and the concentration of Ca was less than 0.5 ppm.
It is seen from the data that the purity level of the raw material was kept unchanged in the jig. Oxidation treatment on wafers was carried out using the wafer boat and as a result all the wafers had uniform oxide films of good quality.

### Comparative Example 1

Grooves for resting wafers 8 were cut in a conventional method for cutting by a diamond tool 15 as shown in FIG.5 to complete a wafer boat and the purity level in the surface region up to 30 µm in depth of a wafer boat was analyzed in a way like the example as above-mentioned.

The results from the analysis were as follows: The concentration of Fe was 0.55 ppm, the concentration of Na was 0.50 ppm, the concentration of Ka was 0.35 ppm and the concentration of Ca was 1.2 ppm.
It is seen from the results that contamination occurred.
In the use of this wafer boat in oxidation treatment, this wafer boat was exposed to hydrogen chloride gas at a temperature of 1000 °C and a time of 20 hours, which treatment is a so-called "purification by high temperature gas," to thereby obtain a wafer having an oxide film of good quality.

### Comparative Example 2

A wafer boat produced in a similar way to that of the comparative example 1 was repeatedly treated in hydrofluoric acid to have been cleaned, while monitoring the surface purity level by the analyses of the etching solution.
In the second run of etching treatment, all the surfaces had been cleaned, but the boat was unable to be used as that for automatic loading, because the width of the opening of each of grooves was increased by more than about 0.1 mm and what's more a disorder in the shapes of the grooves was resulted.

### Comparative Example 3

A wafer boat was prepared in a similar way to that of the example except that one of the outmost ends of the grooves in a row is cut with a diamond cutter and wafers were loaded in the wafer boat to execute oxide-film formation treatment. The result were that the wafers positioned within 2 cm of the outmost groove were of poor quality due to an excessive thickness of the oxide film.

### Effects of the Invention

By forming the resting grooves by laser beam machining no microcrack on the wafer resting members of a quartz glass jig for heat treating silicon semiconductor devices occurs and contamination by impurities is prevented and thus favorable heat-treatment of the silicon semiconductor devices is performed when the jig is used.

## Claims

1. A method of producing a quartz glass jig for heat treatment of silicon wafers, comprising a silicon wafer resting member (5); having a quartz glass board (2) in and along which wafer resting grooves (8) are formed, **characterized in that** the wafer resting grooves are formed by laser beam machining.

2. A method for producing a quartz glass jig as set forth in claim 1, **characterized in that** portions in the neighborhood of each of the wafer resting grooves located within 2 cm of the contact point with a wafer are processed by laser beam machining.

3. A method for producing a quartz glass jig as set forth in claim 1, **characterized in that** the surface region of at least 30 µm in depth of each of the quartz glass parts constructing the quartz glass jig for heat treatment of silicon wafers is formed with a purity level having an iron concentration of 0.4 wt. ppm or less, a sodium concentration of 0.4 wt. ppm or less, a potassium concentration of 0.2 wt. ppm or less and a calcium concentration of 0.8 wt. ppm or less, all on the average, by forming said parts from a quartz glass raw material with the same purity level.

4. A method for producing a quartz glass jig as set forth in claim 1, **characterized in that** the quartz glass board is welded integrally with and supported by a supporting member (7).

5. A method for producing a quartz glass jig as set forth in claim 4, **characterized in that** the quartz glass board is produced by extrusion molding of silicon dioxide molten in a crucible, whereby the raw material of the silicon dioxide has a purity level as follows: iron concentration 0.4 wt. ppm or less, sodium concentration 0.4 wt. ppm or less, potassium concentration 0.2 wt. ppm or less, calcium concentration 0.8 wt. ppm or less, all on the average.

## Patentansprüche

1. Verfahren zur Herstellung einer Haitevorrichtung aus Quarzglas für die Wärmebehandfung von Silizium-Wafem, umfassend ein Bauteil zur Auflage der Silizium-Wafer (5), das eine Quarzglasplatte (2) aufweist, in und entlang derer Lagerillen (8) für die Wafer ausgebildet sind, **dadurch gekennzeichnet, dass** die Lagerillen für die Wafer durch Laserstrahl- Bearbeitung gebildet sind.

2. Verfahren zur Herstellung einer Haltevorrichtung aus Quarzglas nach Anspruch 1, **dadurch gekennzeichnet, dass** benachbarte Bereiche der jeweiligen Lagerillen für die Wafer bis zu einem Abstand von 2 cm vom Wafer-Berührungspunkt mit Laserstrahlen bearbeitet werden.

3. Verfahren zur Herstellung einer Haltevorrichtung aus Quarzglas nach Anspruch 1, **dadurch gekennzeichnet, dass** der Oberflächenbereich aller Quarzglasteile, aus denen die Haltevorrichtung aus Quarzglas für die Wärmebehandlung von Silizium-Wafern besteht, bis zu einer Tiefe von mindestens 30 µm mit einem Reinheitsgrad gebildet wird, der jeweils im Mittel eine Eisenkonzentration von 0,4 Gew.-ppm oder weniger, eine Natriumkonzentration von 0,4 Gew.-ppm oder weniger, eine Kaliumkonzentration von 0,2 Gew.-ppm oder weniger und eine Kalziumkonzentration von 0,8 Gew.-ppm oder weniger aufweist, indem diese Teile aus einem Quarzglas-Ausgangsmaterial mit demselben Reinheitsgrad geformt werden.

4. Verfahren zur Herstellung einer Haltevorrichtung aus Quarzglas nach Anspruch 1, **dadurch gekennzeichnet, dass** die Quarzglasplatte mit einem Stützelement (7) verschweißt und durch dieses gestützt ist.

5. Verfahren zur Herstellung einer Haltevorrichtung aus Quarzglas nach Anspruch 4, **dadurch gekennzeichnet, dass** die Quarzglasplatte durch Strangformen von in einem Tiegel geschmolzenen Siliziumdioxid hergestellt ist, wobei das Ausgangsmaterial des Siliziumdioxids einen mittleren Reinheitsgrad wie folgt aufweist: Eisenkonzentration 0,4 Gew.-ppm oder weniger, Natriumkonzentration 0,4 Gew.-ppm oder weniger, Kaliumkonzentration 0,2 Gew.-ppm oder weniger und Kalziumkonzentration 0,8 Gew.-ppm oder weniger.

## Revendications

1. Procédé de production d'un gabarit de verre quartzeux destiné au traitement thermique de plaques de silicium, comprenant un organe de soutien de plaque de silicium (5), ayant un panneau de verre de quartz (2) dans lequel et le long duquel sont formées des rainures de soutien de plaques (8), **caractérisé en ce que** les rainures de soutien de plaque sont formées par usinage au rayon laser.

2. Procédé de production d'un gabarit de verre quartzeux tel que défini dans la revendication 1, **caractérisé en ce que** des portions à proximité de chacune des rainures de soutien de plaque logées dans un espace de 2 cm du point de contact avec une plaque sont réalisées par usinage de rayon laser.

3. Procédé de production d'un gabarit de verre quartzeux tel que défini dans la revendication 1, **caractérisé en ce que** la région de surface d'au moins 30 µm en profondeur de chacune des parties de verre quartzeux formant le gabarit de verre quartzeux pour le traitement thermique de plaques de silicium est formée avec un degré de pureté ayant une concentration de fer inférieure ou égale à 0,4 en poids ppm, une concentration de sodium inférieure ou égale à 0.4 en poids ppm, une concentration de potassium inférieure ou égale à 0.2 en poids. ppm une concentration de calcium inférieure ou égale à 0.8 en poids ppm, en moyenne, en formant lesdites parties à partir d'un matériau brut de verre quartzeux avec le même niveau de pureté.

4. Procédé de production d'un gabarit de verre quartzeux tel que défini dans la revendication 1, **caractérisé en ce que** le plateau de verre de quartz est soudé intégralement et est supporté par un organe de support (7).

5. Procédé de production d'un gabarit de verre quartzéux tel que défini dans la revendication 1, **caractérisé en ce que** le plateau de verre de quartz est fabriqué par moulage profilé de dioxyde de silicium fondu dans un creuset, le matériau brut de dioxyde de silicium ayant un niveau de pureté comme suit : une concentration de fer inférieure ou égale à 0,4 en poids ppm, une concentration de sodium inférieure ou égale à 0.4 en poids ppm, une concentration de potassium inférieure ou égale à 0.2 en poids ppm une concentration de calcium inférieure ou égale à 0.8 en poids ppm, en moyenne.
